Europäisches Patentamt

European Patent Office

Office européen des brevets

(11) Numéro de publication: **0 360 647**

**A1**

## (12) DEMANDE DE BREVET EUROPEEN

(21) Numéro de dépôt: **89402379.5**

(22) Date de dépôt: **31.08.89**

(51) Int. Cl.⁵: **H 05 K 1/00**
H 05 K 3/04, H 05 K 1/18,
H 05 K 7/06

(30) Priorité: **02.09.88 FR 8811522**

(43) Date de publication de la demande:
**28.03.90 Bulletin 90/13**

(84) Etats contractants désignés: **DE ES GB IT**

(71) Demandeur: **APR COMPOSANTS**
**Route d'Ardus**
**F-82000 Montauban (FR)**

(72) Inventeur: **De Mari, Daniel**
**2 Rue des Cordiers**
**F-82200 Moissac (FR)**

(74) Mandataire: **Berger, Helmut et al**
**Cabinet Z. WEINSTEIN 20, avenue de Friedland**
**F-75008 Paris (FR)**

(54) **Dispositif de codage notamment pour carte à circuits intégrés.**

(57) L'invention concerne un dispositif de codage notamment pour cartes à circuits intégrés.

Ce dispositif comprend une pluralité d'éléments électriquement conducteurs (1) qui relient chacun au moins deux points d'un circuit imprimé et sont susceptibles d'être interrompus entre ces deux points de façon à définir un état de codage numérique par leur état interrompu ou non. Le dispositif est caractérisé en ce qu'une pluralité d'éléments conducteurs (1) est incorporée à un corps réalisé en un matériau isolant de façon à former un composant de codage, que le corps (2) comporte pour chaque élément (1) un évidement (5) ouvert vers l'extérieur et traversé par ledit élément (1) et que la partie ainsi accessible de l'extérieur de cet élément comporte avantageusement une zone de rupture (6) permettant la programmation de l'élément.

L'invention est utilisable pour des cartes à circuits intégrés.

FIG. 1

# Description

## Dispositif de codage notamment pour carte à circuits intégrés.

L'invention concerne un dispositif de codage notamment pour carte à circuits intégrés, du type comprenant une pluralité d'éléments électriquement conducteurs qui relient chacun deux points d'un circuit imprimé et sont susceptibles d'être interrompus entre ces deux points de façon à définir un état de codage numérique par leur état interrompu ou non.

On connaît déjà des dispositifs de codage où chaque élément conducteur formant élément de codage est constitué par un pont conducteur dont les extrémités sont introduites dans des trous pratiqués dans la carte. Ces dispositifs de codage connus ont pour inconvénient majeur que leur pose est liée à la présence des trous dans la carte, ce qui est gênant pour une implantation à forte densité des différents composants électriques ou électroniques des circuits électriques. De plus, ces éléments de codage sont difficilement reprogrammables.

La présente invention a pour but de palier aux dispositifs de codage connu.

Pour atteindre ce but, un dispositif de codage selon l'invention est caractérisé en ce qu'une pluralité d'éléments conducteurs est incorporée à un même corps en matière isolante de façon à former un composant de codage, que le corps comporte pour chaque élément un évidement ouvert vers l'extérieur et traversé par ledit élément et que la partie ainsi accessible de l'extérieur de cet élément comporte une zone de rupture permettant la programmation de l'élément.

Selon une caractéristique avantageuse de l'invention, un élément conducteur qui a été coupé peut être refermé par l'introduction dans l'évidement correspondant entre les deux extrémités séparées d'un organe conducteur tel qu'un plot de contact.

Selon une autre caractéristique avantageuse de l'invention, les surfaces des extrémités et du plot de contact, qui sont destinées à venir en contact les unes avec les autres, sont étamées pour faciliter un raccord par soudage.

Selon encore une autre caractéristique de l'invention, le soudage est effectué à l'aide d'un fer à souder que l'on applique sur l'extrémité extérieure du plot de contact.

Selon encore une autre caractéristique avantageuse de l'invention, les évidements sont réalisés sous forme de passages qui traversent le corps du composant de haut en bas et présentent en dessous des éléments conducteurs une largeur plus grande qu'au-dessus, de façon à provoquer un pliage vers le bas des éléments conducteurs lors de leur rupture.

Selon encore une autre caractéristique avantageuse de l'invention, un composant de codage est réalisé sous forme d'une puce dont les pattes de contact extérieures sont recourbées au niveau de leur partie de fixation sur la carte, permettant le montage du composant par une simple pose sur la surface de la carte.

L'invention sera mieux comprise, et d'autres buts, caractéristiques, détails et avantages de celle-ci apparaîtront plus clairement au cours de la description explicative qui va suivre faite en référence aux dessins schématiques annexés donnés uniquement à titre d'exemple illustrant un mode de réalisation de l'invention, et dans lesquels :

La figure 1 est une vue de dessus d'un dispositif de codage selon la présente invention ;

La figure 2 est une vue en coupe selon la ligne II-II de la figure 1 ; et

La figure 3 est une vue en coupe similaire à celle de la figure 2 où cependant un élément conducteur est refermé à l'aide d'un plot de contact.

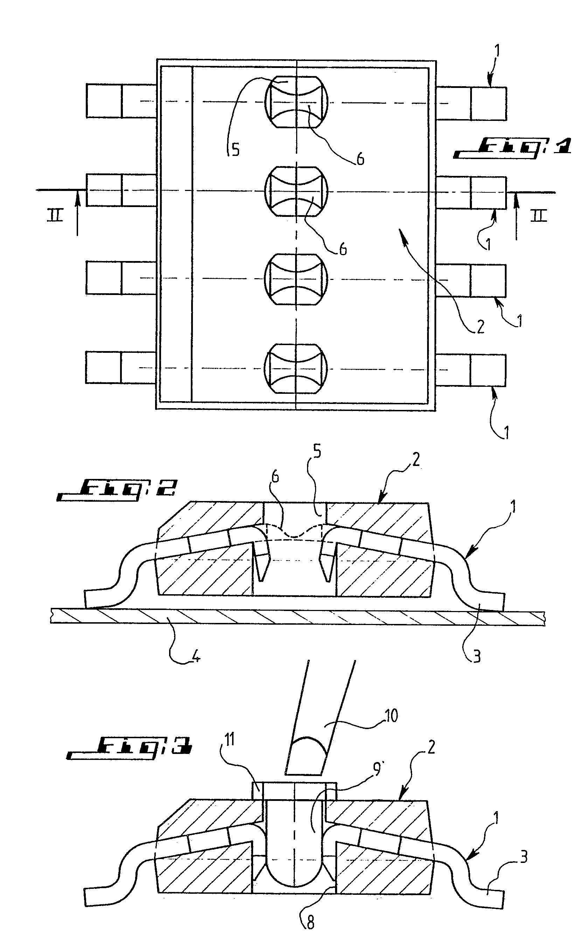

Comme il ressort des figures, un dispositif de codage selon l'invention est réalisé sous forme d'un composant de codage et plus précisément d'une puce de codage. Chaque composant comporte un certain nombre d'éléments électriquement conducteurs 1, chacun en forme d'une lame de forme oblongue. Dans le mode de réalisation représenté à la figure 1, le composant comporte quatre éléments conducteurs 1 qui sont incorporés dans un corps commun 2 réalisé en un matériau électriquement isolant. On constate que chaque lame de codage 1 traverse entièrement le corps 2 et que les deux parties d'extrémité 3 sont dégagées et courbes de façon qu'elles forment des pattes de contact parallèles au plan de la carte, permettant le montage du composant par simple pose à plat sur la surface, par exemple supérieure, de la carte représentée schématiquement en 4.

Le corps 2 comprend au niveau de la partie centrale de chaque élément conducteur un évidement 5 qui est réalisé dans l'exemple représenté par un passage traversant entièrement de haut en bas le corps. Chaque élément conducteur 1 s'étend à travers cet évidement 5. On constate que la partie qui est ainsi exposée et accessible de l'extérieur, de l'élément 1 est conformée en zone de rupture 6 comme cela est indiqué en traits interrompus sur la figure 2. Ainsi selon que l'élément 1 est interrompu ou non, celui-ci détermine l'objet numérique. Par conséquent chaque élément conducteur 1 constitue un élément de codage.

Les figures 2 et 3 montrent également qu'un évidement 5 en forme de passage est plus large dans la direction longitudinale de l'élément 1, dans sa partie 7 située en-dessous de celui-ci qu'au dessus. Cette mesure permet d'obtenir que l'élément de codage lors de sa rupture se replie élastiquement vers le bas, comme cela est illustré à la figure 2.

Un élément de codage selon l'invention qui a été coupé peut être refermé et ainsi facilement reprogrammé. La figure 3 montre qu'il suffit à cette fin d'introduire dans le passage 5, entre les deux extrémités séparées un organe conducteur tel qu'un plot de contact 9. Le raccord entre les deux parties séparées de l'élément 1 et du plot 9 se fait avantageusement par soudure. A cette fin les surfaces des deux parties séparées de l'élément 1 et du plot 9, qui sont destinées à venir en contact sont étamées et la soudure est accomplie par application par exemple d'un fer à souder 10 sur la partie extérieure du plot 9. On constate que cette extrémité est réalisée en forme de tête 11 permettant au plot de prendre appui sur la surface supérieure du corps 2.

Bien entendu, de nombreuses modifications peuvent être apportées au composant de codage selon l'invention, sans sortir du cadre de l'invention. Ainsi la forme des éléments conducteurs et du corps 2 peut être différente. L'évidement 5 et la zone de rupture 6 peuvent avoir tout autre forme appropriée. Le plot de contact peut également être de tout autre nature permettant de refermer les deux parties de l'élément de codage après une rupture.

Le dispositif de codage selon l'invention, en forme de puce de codage peut présenter des pôles par exemple au nombre de 2, 4, 6, 8 ou plus. Le pas d'écart des pôles n'est pas lié aux écarts des trous pratiqués dans la carte à circuits imprimés. Le pas sera avantageusement de 1,27 mm. La puce de codage selon l'invention est juxtaposable au pas de 0,27 mm. Mais des pas de 2,54 mm habituels dans la technique CMS sont également possibles.

## Revendications

1. Dispositif de codage notamment pour cartes à circuits intégrés du type comprenant une pluralité d'éléments électriquement conducteurs qui relient chacun au moins deux points d'un circuit imprimé et sont susceptibles d'être interrompus entre ces deux points de façon à définir un état de codage numérique par leur état interrompu ou non, caractérisé en ce qu'une pluralité d'éléments conducteurs (1) est incorporée à un corps réalisé en un matériau isolant de façon à former un composant de codage, que le corps (2) comporte pour chaque élément (1) un évidement (5) ouvert vers l'extérieur et traversé par ledit élément (1) et que la partie ainsi accessible de l'extérieur de cet élément comporte avantageusement une zone de rupture (6) permettant la programmation de l'élément.

2. Dispositif selon la revendication 1, caractérisé en ce qu'un élément conducteur (1) qui a été coupé peut être refermé par l'introduction dans l'évidement correspondant (5) entre les deux extrémités séparées, d'un organe conducteur (9) tel qu'un plot de contact.

3. Dispositif selon l'une des revendications 1 ou 2, caractérisé en ce que l'organe conducteur rapporté (9) peut être relié par soudure aux extrémités séparées d'un élément conducteur (1).

4. Dispositif selon la revendication 3, caractérisé en ce que les surfaces des extrémités d'un élément conducteur (1) et du plot de contact (6), qui sont destinées à venir en contact les unes avec les autres, sont étamées pour faciliter un raccord par soudage, avantageusement à l'aide d'un fer à souder (10) que l'on applique sur l'extrémité extérieure de l'organe conducteur (9).

5. Dispositif selon l'une des revendications précédentes, caractérisé en ce que les évidements (5) sont réalisés sous forme de passage qui traverse le corps (2) de haut en bas et présente en dessous des éléments conducteurs une largeur plus grande qu'au-dessus de façon à provoquer un pliage vers le bas des éléments conducteurs, lors de leur rupture.

6. Dispositif selon l'une des revendications 2 à 5, caractérisé en ce que l'organe conducteur (9) formant plot de contact présente une partie formant tête (11) par laquelle il prend appui sur la surface supérieure du corps (2).

7. Dispositif selon l'une des revendications précédentes, caractérisé en ce qu'un composant de codage est réalisé sous forme d'une puce dont les pattes de contact extérieur sont recourbées au niveau de leurs parties de fixation sur la carte, permettant le montage du composant par une simple pose sur la surface (4) de la carte.

8. Dispositif selon la revendication 7, caractérisé en ce que les pattes de contact sont formées par les extrémités des éléments conducteurs (1) qui traversent le corps (2).

EP 0 360 647 A1

Fig. 1

Fig. 2

Fig. 3

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | FR-A-1 309 979  (MACHINES BULL)<br>* figure 3; page 2, colonne gauche, ligne 17 - page 2, colonne droite, ligne 17 *<br>--- | 1,2 | H 05 K    1/00<br>H 05 K    3/04<br>H 05 K    1/18<br>H 05 K    7/06 |
| Y | FR-A-2 137 991  (M. BRANDI)<br>* figures 6-12; page 2, ligne 23 - page 3, ligne 18; page 4, ligne 22 - page 5, ligne 30 * | 1,2 | |
| A | | 4-6 | |
| A | DE-A-3 306 120  (SCHULTE-TIGGES)<br>* figures 1-6B; page 17, ligne 8 - page 21, ligne 17 *<br>--- | 1-6 | |
| A | EP-A-0 256 581  (RTC-COMPELEC)<br>* figures 4B,4C,5; colonne 6, ligne 9 - colonne 7, ligne 4 *<br>--- | 1,2,7,8 | |
| A | FR-A-1 491 397  (MECI)<br>* figures 1-4; page 2, colonne gauche, alinéa 5 - page 2, colonne droite, alinéa 1 *<br>--- | 1 | DOMAINES TECHNIQUES RECHERCHES (Int. Cl.5) |
| A | FR-A-2 243 580  (PICO)<br>* figures 1-3; page 2, lignes 17-34 *<br>----- | 1,3,4 | H 01 R   29/00<br>H 05 K    1/00<br>H 05 K    3/00<br>H 05 K    7/00 |

Le présent rapport a été établi pour toutes les revendications

| Lieu de la recherche | Date d'achèvement de la recherche | Examinateur |
|---|---|---|
| BERLIN | 27-11-1989 | HAHN G |

EPO FORM 1503 03.82 (P0402)